Europäisches Patentamt

European Patent Office

Office européen des brevets

(11) Publication number: **0 345 760**
**A2**

# EUROPEAN PATENT APPLICATION

(21) Application number: **89110302.0**

(22) Date of filing: **07.06.89**

(51) Int. Cl.⁴: **H01L 23/10**

(30) Priority: **08.06.88 IT 2088588**

(43) Date of publication of application:
**13.12.89 Bulletin 89/50**

(84) Designated Contracting States:
**DE FR GB NL SE**

(71) Applicant: **SGS-THOMSON
MICROELECTRONICS s.r.l.
Via C. Olivetti, 2
I-20041 Agrate Brianza Milano(IT)**

(72) Inventor: **de Martiis, Carlo Cognetti
Viale Ranzoni 1
I-20100 Milano(IT)**

(74) Representative: **Klunker . Schmitt-Nilson .
Hirsch
Winzererstrasse 106
D-8000 München 40(DE)**

(54) **Semiconductor device in plastic case with means of anchoring between chip-bearing slice and plastic body.**

(57) In order to anchor a carrying metal slice (1) of a semiconductor device to a case being formed by pressure-injection of resin, the slice (1), which carries a semiconductor chip (3) comprises at least one part (2) that is depressed in relation to the surface on which the chip (3) is mounted, wherein said depressed part (2) has at least one hole. Plastic of the case extends through the hole to the interior of the volume delimited by the depressed part and by the chip (3) carried by the metal slice (1).

FIG. 5

# SEMICONDUCTOR DEVICE IN PLASTIC CASE WITH MEANS OF ANCHORING BETWEEN CHIP-BEARING SLICE AND PLASTIC BODY

The present invention relates to semiconductor devices and, more particularly, to plastic cases for integrated circuits adapted for "surface mounting".

As is well known, a case of plastic comprises a carrying slice for a chip made of semiconductor material, usually silicon, which constitutes the active element of the device, a multiplicity of rigid electrical conductors electrically connected to predetermined areas of the chip by means of thin metal wires and a body of plastic, usually epoxy resin, which embodies the whole with the exception of the terminal ends of the rigid conductors constituting the legs of the device. The carrying slice and the electrical conductors are usually obtained by shearing out a single strip of sheet metal. In the case of devices intended for surface mounting, the legs are folded in such a way that their end portions are located in the same plane, substantially coincident with the plane of one of the main surfaces of the body of plastic.

For surface mounting, the devices are bonded to the metal tracks of a printed circuit board via a process using a relatively high temperature, typically 200 - 250° C, and of relatively long duration (some tens of seconds). It has been discovered that said process produces within the plastic body phenomena that modify the physical characteristics of the materials and the mechanical stability of the case. In particular, when the ratio of the thickness of the plastic body to the surface of the metal slice of the carrier, determined by the dimensions of the chip, is small, such modifications can cause the case to break.

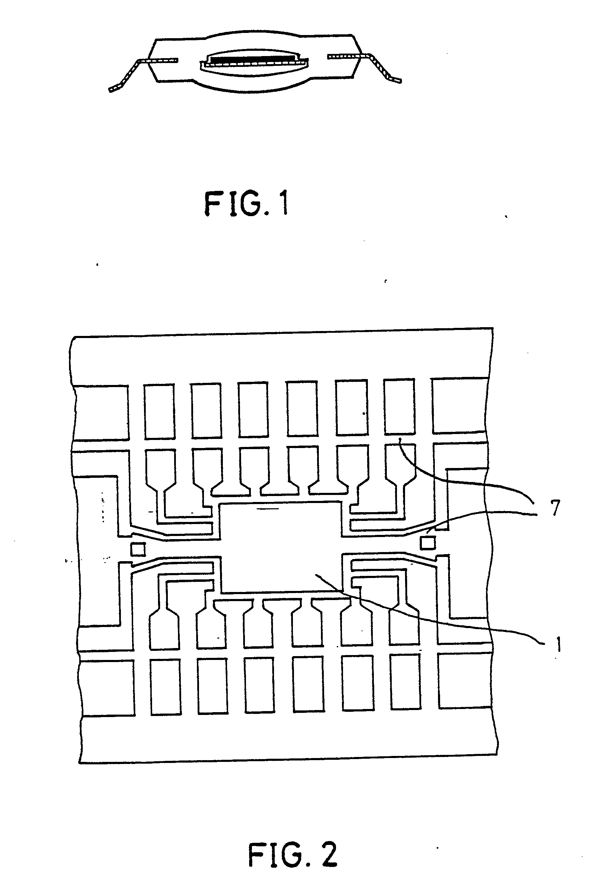

The phenomenon, shown in Fig. 1, appears to occur in the following manner:
- water, present in the resin by adsorption from the environment, migrates to both the inner and outer surfaces of the body;
- if the adherence between the plastic body and the parts embodied therein is not perfect or fails because of the different expansions of the materials during the thermal cycle, a cavity may form between the plastic and the chip and between the plastic and the lower surface of the carrying slice, in which water can accumulate;
- due to the elevated temperature, the water evaporates and applies pressure to the walls of the cavity;
- the pressure of the vapor within the body deforms the walls of the case and, in limit cases, causes it to break (it is be noted that the wall that gives way first is the wall which is adjacent to the metal slice and is the thinnest).

In view of the present tendency to make increasingly complex integrated circuits, employing chips of ever greater dimensions but without increasing the dimensions of the cases, it is obvious that the phenomenon described above constitutes a serious problem, since it imposes a limit on the possibility of using certain standard cases.

In order to overcome the above described destructive effect, which is known to those skilled in the art as "pop corn noise", several expedients have been recommended, such as:
- elimination of the adsorbed water by baking the pieces prior to bonding,
- protection of the pieces during storage so as to avoid adsorption of water,
- improvement of adhesion between the resin and the components of the device within the body by treating, chemically or mechanically, the surface of the carrying slice,
- reduction of the surface of contact between resin and slice, providing a window which passes through the body of resin to the surface of the slice.

All the expedients above mentioned have more or less serious disadvantages. In particular, the first three expedients require costly additional treatments, and the fourth expedient leads to a loss of dependability due to the high risk of contamination of the chip.

The invention has for its object the provision of a semiconductor device in a case of the type described above, which is more resistant to degenerative effects due to the bonding process and which requires no costly modifications of the manufacturing process.

This object is achieved by means of a device having the characteristics set forth in the appended claims.

One embodiment of the invention will be described hereinbelow by way of example, which is not limitative, with reference to the accompanying drawings, in which:

- Fig. 1 shows a device made of plastic for surface mounting known from the prior art and which is deformed by thermal strains during the bonding process,

- Fig. 2 shows an enlarged portion of a strip of sheet metal sheared out along a customary pattern and used for producing a device of the type shown in Fig. 1;

- Fig. 3 is a perspective and enlarged view of a carrying slice of a device according to the invention, and

- Figs. 4 and 5 are a schematic top plan view and a cross-sectional view, respectively, of a part of the device according to the invention prior to encapsulation in plastic.

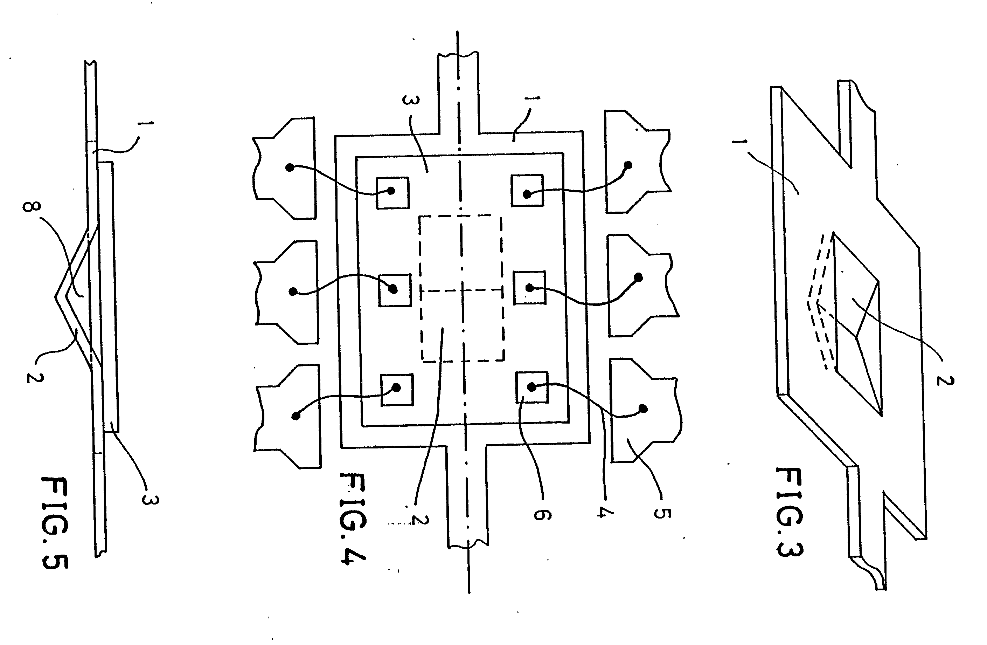

With reference to the drawings, in which like reference numerals denote like or equivalent parts, the carrying slice 1 in Fig. 3 constitutes the central part, modified in accordance with the invention, of a frame structure of the type shown in Fig. 2. In particular, the slice 1 has a quadrangular part 2 sheared out along two opposing sides and depressed. Advantageously, the formation of the depressed part 2 occurs concurrently with the shearing out of the strip of sheet metal necessary for producing the frame.

The successive steps for manufacturing the device are usually those taken for this type of cases. In particular, they include the bonding of a silicon chip 3 made such as to form an integrated circuit on the carrying slice 1, the bonding of thin wires 4 to the conductors 5 of the frame and to appropriate areas 6 of the chip 3 constituting the electrical terminals of the integrated circuit, the formation of an encapsulating body of plastic (not shown) by pressure-injection of a thermosetting epoxy resin in a suitable mold and the shearing out of the portions 7 of sheet metal (Fig. 2) interconnecting the conductors of one frame and the adjacent frames. As can particularly be seen in Fig. 5, the depressed part 2 forms a kind of eyelet or channel 8 through which the resin can flow during the pressure-injection process. Following the hardening, the resin left in the channel ensures a solid anchoring of the slice to the body of the case, as a result of which the pressure of the water vapor in any cavity between the resin and the slice during the bonding of the device to a printed circuit board can act practically only beneath the edges of the slice, thereby to a large extent preventing the case from breaking.

It should also be noted that the device according to the invention is particularly advantageous in that it requires no modifications of the manufacturing process, but only a small modification of the equipment for shearing out the strip of sheet metal. In particular, in order to produce the device in accordance with the above described embodiment, said equipment comprises a punch designed to shear out partially one part of the slice and to depress the same so as to form the eyelet or channel 8.

While one embodiment of the invention has been shown and described, it is obvious that numerous modifications can be made without departing from the scope of the inventive concept. For example, in the same slice there can be formed more than one depressed part, or the depressed part can have a form other than the quadrangle shown, or it may have one or more holes obtained other than by shearing.

## Claims

A semiconductor device comprising a carrying metal slice (1), a chip (3) of semiconductor material fixed to the carrying slice (1), a multiplicity of metal conductors (5) adjacent to the carrying slice (1), a multiplicity of metal wires (4) which connect predetermined points (6) of the semiconductor chip (3) to the metal conductors (5), and a body of plastic which embodies the whole with the exception of the end portions of the metal conductors (5), **characterized** in that the carrying metal slice (3) has at least one part (2) that is depressed in relation to the surface on which the chip (3) of semiconductor material is mounted, said depressed part (2) having at least one hole, and in that the plastic of the body extends through the hole to the interior of the volume delimited by the depressed part and by the semiconductor chip (3).

FIG. 1

FIG. 2

FIG.3

FIG.4

FIG.5